Europäisches Patentamt

European Patent Office

Office européen des brevets

(11) Publication number: **0 358 974**
**A2**

## (12) EUROPEAN PATENT APPLICATION

(21) Application number: **89115193.8**

(22) Date of filing: **17.08.89**

(51) Int. Cl.5: **H01L 39/24**

(30) Priority: **18.08.88 JP 203892/88**

(43) Date of publication of application:
**21.03.90 Bulletin 90/12**

(84) Designated Contracting States:
**DE FR GB**

(71) Applicant: **Mitsubishi Metal Corporation**
**5-2, Otemachi 1-chome Chiyoda-ku**
**Tokyo(JP)**

(72) Inventor: **Sakai, Kazuhiro Mitsubishi Kinzoku**
**Chuo Kenkyusho 1-297 Kitabukuro-cho**
**Omiya-shi Saitama-ken(JP)**
Inventor: **Yanagisawa, Akio Mitsubishi**
**Kinzoku**
**Chuo Kenkyusho 1-297 Kitabukuro-cho**
**Omiya-shi Saitama-ken(JP)**
Inventor: **Kan, Yoshihiko Mitsubishi Kinzoku**
**Chuo Kenkyusho 1-297 Kitabukuro-cho**
**Omiya-shi Saitama-ken(JP)**

(74) Representative: **Strehl, Schübel-Hopf,**
**Groening**
**Maximilianstrasse 54 Postfach 22 14 55**
**D-8000 München 22(DE)**

(54) **Process for forming thin film of compound metal oxide.**

(57) Film of a compound metal oxide of a specific composition can be formed by dissolving organic acid salts of Bi, Ca, Sr and Cu in the same content ratio with respect to metals as that in the object compound in a solvent which dissolves all of said salts, coating a substrate with the thus formed solution and subjecting the substrate to heat-treatment at a temperature between 750°C and 900°C. The thus formed film is free from voids or unreacted phases and is of high density.

## Process for forming thin film of compound metal oxide

### Field of the Invention

This invention relates to a process for forming a thin film of a compound metal oxide. More specifically, this invention relates to a process for forming a thin film of a compound metal oxide of a specific composition which is useful for superconductive materials, magnetic sensors and the like. Compound metal oxides of bismuth, calcium, strontium and copper of specific compositions are promising substances which exhibit superconductivity at temperatures not lower than 70K.

### Background of the Invention

Typical processes known today for forming a thin film of compound metal oxide comprise: preparing an object compound metal oxide in the form of powder; forming a target of said powder by hot pressing or the like; and forming a thin film on a substrate by sputtering or similar methods using said target.

Powders of compound metal oxides have been prepared by the following processes:

(1) a process comprising physically pulverizing and mixing oxides or carbonates of the respective metals, firing the resulting mixture so as to effect a solid phase reaction and pulverizing the resulting oxide.

(2) a process comprising preparing a homogeneous aqueous solution of water-soluble salts such as nitrate, hydrochloride or sulfate of the respective metals, adding hydroxide ions, oxalate ions or the like to the solution to form an insoluble coprecipitate of hydroxides, carbonates, oxalates or the like, collecting the coprecipitate, firing the precipitate and pulverizing the resulting compound oxide.

(3) a process comprising preparing a homogeneous solution of an alkoxide, a $\beta$-diketo complex or a $\beta$-ketoester complex of the respective metals by dissolving these in an organic solvent, hydrolyzing the metal compounds, collecting and firing the formed precipitate and pulverizing the resulting compound oxide.

As mentioned above, in conventional methods, the step wherein powders of compound metal oxides are prepared is essential prior to forming a thin film of a compound metal oxide and therefore the preparation processes are inevitably complicated.

Further, these methods for preparing oxide powders have problems discussed below.

In the process (1), starting materials are mixed and fired in the state of powder. Therefore, the reaction proceeds from boundaries between powder particles and is liable to leave unreacted cores. This may result in the formation of oxide powders the composition of which deviates from the intended composition.

In the process (2), since the condition for forming precipitate in the solution differs from element to element, the composition of the formed coprecipitate is in many cases different from the content ratio of the component elements in the solution. Therefore, the composition of the produced oxides inevitably deviates from that intended. Further, inorganic anions ($NO_3^-$, $Cl^-$, $SO_4^{2-}$, etc.) from starting materials remain as impurities even after firing and degrade the properties of the product.

In the process (3), precipitates of the intended composition can be obtained. However, this process have some disadvantages, one of which derives from the fact that the metal alkoxides are very unstable and are readily hydrolyzed by moisture in the air to form precipitate of oxide or hydroxide.

Further, expensive apparatuses such as a sputtering apparatus, a hot press or the like are required when thin film is formed by sputtering.

In addition to the above conventional processes there are also known processes wherein sputtering is not used:

(a) a process comprising dissolving an alkoxide, a $\beta$-diketo complex , a $\beta$-diketoester or the like of the desired component metals in an organic solvent in a desired content ratio to form a homogeneous solution, applying the solution on a substrate, hydrolyzing the mixed solutes with moisture in the air and heating it to form a thin film of compound metal oxides;

(b) a process comprising applying a solution of organic acid salts of the desired metals on a substrate, drying and firing the salts at a temperature of 200-500°C at which these organic acid salts decompose, repeating the procedures of said coating and firing several times to attain the intended film thickness and finally firing the formed coating at 700-1,000°C to form a thin film of a compound metal oxide.

However, the method (a) involves a difficulty in that the solution containing alkoxide is unstable, as discussed above.

With respect to the above process (b), it had been believed as follows. In order to form a thick film, it is preferable to repeat the coating and firing at not higher than 500°C until a desired thickness is attained and finally to fire the coated layer at 700-1,000°C. If firing at a temperature over 700°C is effected at every coating step, a uniform thick film cannot be formed. In this known two step firing process, however, the formation of pores and voids in the surface layer by the decomposition of the remaining carbonates is unavoidable.

We restudied the above described process and have found that thick good uniform compound oxide film can be formed, even though the coating and firing at a temperature over 700°C are repeated until a desired thickness is attained, if the coated film is fired at a temperature not higher than 900°C.

The reason why the two step firing method had been abided by is surmised to be that those skilled in the art had thought as follows: By heating over 750°C, the organic acid salts are converted to oxide in a single step and formation of pores is avoided. However, if the organic salts are heated over 900°C, one layer of the organic acid salts is sintered excessively and a thick film with overall uniformity cannot be formed when coating and firing are repeated. Prior to the present invention, those skilled in the art were too meticulous and they did not notice the upper limit temperature causing excessive sintering.

Disclosure of the Invention

The present invention provides process for forming thin film of a compound metal oxide of a specific composition which comprises: dissolving organic acid salts of Bi, Ca, Sr and Cu in the same content ratio with respect to metals as that in the object compound in a solvent which dissolves all the salts, coating a substrate with the thus formed solution and subjecting the substrate to heat-treatment at a temperature between 750°C and 900°C, said procedure of coating and heat-treatment being repeated until the desired thickness of the film is attained.

In the present invention, organic acid salts mean those represented by the formula $M(OOCR)x$ wherein M is a metal such as bismuth, calcium, strontium or copper. In the case where M is bismuth, $x = 3$, and in the case where M is strontium, calcium or copper, $x = 2$. R is a hydrocarbyl group having 1-18 carbon atoms. Specific examples of organic acid salts are acetate, n-caproate, caprylate, 2-ethylhexanoate, stearate, naphthenate, oleate, linoleate, etc.

In the present invention, water and organic solvents are usable for dissolving metal organic acid salts insofar as they dissolve the metal organic acid salts and do not form precipitate. Water, alcohols such as ethanol, propanol and butanol, aliphatic and aromatic hydrocarbons such as hexane, octane, decane, benzene, toluene and xylene, cellosolves such as methyl cellosolve and ethyl cellosolve can be used alone or in combination.

In the process of the present invention, coating of the substrate is carried out by dipping, spraying, spincoating or the like. If necessary, the coated substrate may be dried between room temperature and the decomposition temperature of the organic acid salts of the metals.

In the present invention, firing is carried out at a temperature over the decomposition temperature of the carbonates of the above compound metals. The temperature will be not lower than 750°C for the compound salts of Bi, Ca, Sr and Cu. If it is lower than 750°C, carbonates will be formed which remain in the fired product and prevent formation of the compound oxide of the desired crystalline structure. The time period for each firing is not specifically limited. However, when it is too short, thermal decomposition will be imcomplete. On the other hand, when the firing time is too long, metal salts will react with components of the substrate and the formed oxide will decompose. In either case the results will be unsatisfactory. Therefore, the time for the heat treatment is preferably from 10 minutes to an hour.

According to the present invention, films of a compound metal oxide can be easily prepared which is free from pores or crevices or unreacted phases and which is of high density and of the composition which is the same as the intended composition. In the process of the present invention, it is not necessary to preliminarily prepare the powder of the metal oxides nor to use expensive apparatuses such as a sputtering apparatus and, therefore, the process of the present invention can be carried out with ease.

Specific Description of the Invention

Now the invention will be illustrated by way of working examples.

Example 1

Acetic acid salts of bismuth, calcium, strontium and copper were mixed in the molar ratio of 2:2:2:3 and an aqueous solution thereof was prepared so as to correspond to a 5% solution of the metal oxides. The solution was applied to a yttrium-stabilized zirconia substrate by spraying. After it was dried at 110°C for 15 minutes, it was fired at 780°C for 20 minutes. The procedures of coating, drying and firing were repeated 20 times. The superconductivity critical temperature (Tc) of the thus formed film was measured: Tc (onset) = 85K, Tc (end) = 70K. The superconductivity critical current density was also measured: Jc = 20000 A/cm² at 10K. It was confirmed by SEM observation that the product was a film of high density in which particles having a particle size of about 2μm were closely packed without pores or voids. Observation of the cross section showed that the film thickness was 2μm. In X-ray diffraction analysis, only the peaks corresponding to (OOn) faces (wherein n is an integer) were observed, which indicates orientation in the direction of the c-axis.

Example 2

Bismuth linoleate, calcium linoleate, strontium 2-ethylhexanoate and copper 2-ethylhexanoate were mixed in the molar ratio of 2:2:2:3 and a 2-ethylcellosolve solution thereof was prepared so as to correspond to a 5% solution of the metal oxides. The solution was applied to a single crystal substrate of strontium titanate by dipping. After it was dried at 150°C for 15 minutes, it was fired at 790°C for 30 minutes. The procedures of coating, drying and firing were repeated 10 times. The superconductivity critical temperature (Tc) of the thus formed film was measured: Tc (onset) = 90K, Tc (end) = 73K. The superconductivity critical current density was also measured: Jc = 30000 A/cm² at 10K. It was confirmed by SEM observation that the product was a film of high density in which particles having a particle size of about 2μm were closely packed without voids. Observation of the cross section showed that the film thickness was 3μm. In X-ray diffraction analysis, only the peaks corresponding to (OOn) faces (wherein n is an integer) were observed, which indicates orientation in the direction of the c-axis.

Example 3

2-Ethylhexanoates of bismuth, calcium, strontium and copper were mixed in the molar ratio of 2:2:2:3 and a toluene solution thereof was prepared so as to correspond to a 5% solution of the metal oxides. The solution was applied to a single crystal substrate of magnesia by spin-coating. After it was dried at 150°C for 15 minutes, it was fired at 800°C for 15 minutes. The procedures of coating drying and firing were repeated 5 times. The superconductivity critical temperature (Tc) of the thus formed film was measured: Tc (onset) = 92K, Tc (end) = 77K. The superconductivity critical current density was also measured: Jc = 40000 A/cm² at 10K. It was confirmed by SEM observation that the product was a film of high density in which particles having particle size of about 2μm are closely packed without voids. Observation of the cross section showed that the film thickness was 0.5μm. It is surmised that each particle is disc-shaped. In the X-ray diffraction analysis, only the peaks corresponding to (OOn) faces (wherein n is an integer) were observed, which indicates orientation in the direction of the c-axis.

Example 4

2-Ethylhexanoates of bismuth, calcium, strontium and copper were mixed in the molar ratio of 1:1:1:2 and a toluene solution thereof was prepared so as to correspond to a 5% solution of the metal oxides. The solution was applied to a single crystal substrate of magnesia by in-coating. After it was dried at 150°C for 15 minutes, it was fired at 800°C for 15 minutes. The procedures of coating, drying and firing were repeated 5 times. The superconductivity critical temperature (Tc) of the thus formed film was measured: Tc (onset) = 92K, Tc (end) = 77K. The superconductivity critical current density was also measured: Jc = 40000 A/cm² at 10K. It was confirmed by SEM observation that the product was a film of high density in which particles having a particle size of about 2μm were closely packed without voids. Observation of the cross section showed that the film thickness was 2μm. In X-ray diffraction analysis, only the peaks corresponding to (OOn) faces (wherein n is an integer) were observed, which indicates orientation in the direction of the c-axis.

Comparative Example 1

The same solution as prepared in Example 3 was applied to a single crystal substrate of magnesia by spin-coating. After it was dried at 150°C for 15 minutes, it was fired at 500°C for 30 minutes. The procedures of coating, drying and firing were repeated 20 times. The coated substrate was further fired at 800°C for 60 minutes. The superconductivity critical temperature (Tc) of the thus formed film was measured: Tc (onset) = 85K, Tc (end) = 20K. The superconductivity critical current density was also measured: Jc = 200 A/cm². Particles having a particle size of about 2μm were observed by SEM observation. However, voids of 1-2μm were also observed. Observation of the cross section showed that the film thickness was 5μm. In the X-ray diffraction analysis, peaks corresponding to the other faces than (OOn) faces were observed which indicates that the tendency to orient in the direction of the c-axis is not so remarkable.

Comparative Example 2

The procedures of Comparative Example 1 were repeated except that the firing temperature after coating was set to 600°C and 700°C. The results were Tc (end) = 22K, 25K and Jc = 210, 220 A/cm² for the respective temperatures. Voids of 1-2μm in diameter were observed by SEM observation and observation of the film cross section showed that the film thickness was 5μm. The results of X-ray diffraction analysis were almost the same as in Comparative Example 1.

**Claims**

1. A process for forming thin film of a compound metal oxide of a specific composition which comprises: dissolving organic acid salts of Bi, Ca, Sr and Cu in the same content ratio with respect to metals as that in the object compound in a solvent which dissolves all the salts, coating a substrate with the thus formed solution and subjecting the substrate to heat-treatment at a temperature between 750°C and 900°C, said procedure of coating and heat-treatment being repeated until the desired film thickness is attained.

2. The process for forming thin film of a compound metal oxide of a specific composition as recited in Claim 1, wherein salts of 2-ethylhexanoic acid, caprylic acid, linolic acid or naphthenic acid is used.

3. The process for forming thin film of a compound metal oxide of a specific composition as recited in Claim 1, wherein said solvent is selected from the group comprising isopropyl alcohol, n-, sec- and tert-butanol, benzene, toluene, xylene and hydrocarbons having 8-12 carbon atoms.